# EUROPEAN PATENT SPECIFICATION

(11) **EP 3 185 573 B1**
(45) Date of publication and mention of the grant of the patent: **17.07.2019**
(21) Application number: 16202558.9
(22) Date of filing: 07.12.2016
(51) Int. Cl.: H04N 21/436, H04N 21/439

(54) **METHOD AND DEVICE FOR PLAYING AUDIO**
VERFAHREN UND VORRICHTUNG ZUR WIEDERGABE VON AUDIO
PROCÉDÉ ET DISPOSITIF DE LECTURE AUDIO

(30) Priority: 23.12.2015 CN 201510980320
(43) Date of publication of application: 28.06.2017
(73) Proprietor: Xiaomi Inc., Beijing 100085 (CN)
(72) Inventor: LONG, Quanming, Beijing 100085 (CN); LONG, Guiming, Beijing 100085 (CN); SUN, Taozheng, Beijing 100085 (CN)
(74) Representative: Underwood, Nicolas Patrick

(56) References cited:
- US-A1- 2014 047 487
- US-A1- 2015 128 194

## Description

### TECHNICAL FIELD

The present invention relates to the field of terminal technology, and more particular, to a method and a device for playing audio.

### BACKGROUND

A split type TV refers to a TV set of which an image displaying part, a signal processing part and an audio system are separated. In general, a split type TV may include a standalone screen and a split type host. The standalone screen may be configured to display images, and the split type host may include a built-in audio system to process signals and output sound. While updating hardware configuration of the split type TV, it is possible to directly replace the split type host while keeping the standalone screen, thereby reducing the cost for hardware configuration upgrade. Accordingly, the split type TV has become more and more popular. For example, a split-type TV is commercialized under the commercial name Mi TV 3 by the Chinese company Xiaomi, and a split-type host is commercialized under the commercial name Mi TV Bar by the Chinese company Xiaomi.

Currently, further to be used in conjunction with the standalone screen, the split type host can obviously be externally connected to a third party terminal and be used in conjunction with the third party terminal. The third party terminal may, for example, include a third party TV, a disk player, a general player and the like. Due to the fact that audio may be played either by the built-in audio system of the split type host, or by the externally connected third party terminal, while the audio is generally required to be played by one device, it is necessary to provide a method for playing audio when the split type host is externally connected to the third party terminal. For example, a third party terminal may be produced by a manufacturer different from the manufacturer of the split-type TV.

### SUMMARY

Accordingly, the present invention provides a method and a device for playing audio, in accordance with claims which follow.

In order to overcome the problems existing in the prior art, the present invention provides a method and a device for playing audio.

According to a first aspect, the present invention relates to a method for playing audio, the method including:acquiring a first audio decoding parameter, the first audio decoding parameter being an audio decoding parameter of a third party terminal externally connected to a split type host, the first audio decoding parameter being used for describing a converting capability for converting a digital audio signal into an analog audio signal; comparing the first audio decoding parameter with the second audio decoding parameter and selecting a device with a greater converting capability from the third party terminal and the split type host according to the first audio decoding parameter and a second audio decoding parameter, the second decoding parameter being an audio decoding parameter of the split type host; and
playing the audio using the selected device,
wherein both the first and second audio decoding parameters include at least a scheme for audio decoding.

According to a particular embodiment, in a first possible implementation of the above first aspect, the first and second audio decoding parameters further include at least one of a sampling frequency and a number of audio channel.

According to a particular embodiment, the step of selecting a device with a greater converting capability from the third party terminal and the split type host according to the first audio decoding parameter and a second audio decoding parameter includes:
determining a first number and a second number, the first number being a number of the scheme for audio decoding included in the first audio decoding parameter, and the second number being a number of the scheme for audio decoding included in the second audio decoding parameter;
determining that the third party terminal is the device with a greater converting capability when the first number is greater than the second number; and
determining that the split type host is the device with a greater converting capability when the first number is smaller than the second number.

According to a particular embodiment, after the step of determining a first number and a second number, the method further includes:
when the first number equals to the second number and when the first and second audio decoding parameters further include a sampling frequency, acquiring a first sampling frequency and a second sampling frequency, the first sampling frequency being a sampling frequency included in the first audio decoding parameter, and the second sampling frequency being a sampling frequency included in the second audio decoding parameter;
determining that the third party terminal is the device with a greater converting capability when the first sampling frequency is greater than the second sampling frequency; and
determining that the split type host is the device with a greater converting capability when the first sampling frequency is smaller than the second sampling frequency.

In conjunction with the second possible implementation of the first aspect, in a fourth possible implementation of the above first aspect, after the step of determining a first number and a second number, the method further includes:
when the first number equals to the second number and when the first and second audio decoding parameters further include a number of audio channel, acquiring a first number of audio channel and a second number of audio channel, the first number of audio channel being a number of audio channel included in the first audio decoding parameter, and the second number of audio channel being a number of audio channel included in the second audio decoding parameter;
determining that the third party terminal is the device with a greater converting capability when the first number of audio channel is greater than the second number of audio channel; and
determining that the split type host is the device with a greater converting capability when the first number of audio channel is smaller than the second number of audio channel.

According to a particular embodiment, the step of acquiring a first audio decoding parameter further includes:
reading an extended display identification data (EDID) of the third party terminal through a designated interface; and
acquiring the first audio decoding parameter from the EDID of the third party terminal.

According to a particular embodiment, the step of acquiring the first audio decoding parameter from the EDID of the third party terminal includes:
acquiring a data document from the EDID of the third party terminal according to a designated path; and
acquiring the first audio decoding parameter from the data document.

In conjunction with anyone possible implementation of the first aspect to the six possible implementation of the first aspect, in a seventh possible implementation of the above first aspect, before the step of selecting a device with a greater converting capability from the third party terminal and the split type host according to the first audio decoding parameter and a second audio decoding parameter, the method includes:
reading an EDID of the split type host; and
acquiring the second audio decoding parameter from the EDID of the split type host.

According to a particular embodiment, the step of selecting a device with a greater converting capability from the third party terminal and the split type host according to the first audio decoding parameter and a second audio decoding parameter includes:
acquiring a third audio decoding parameter when the split type host is further externally connected to a third party player source having an audio playing function, the third audio decoding parameter being an audio decoding parameter of the third party player source; and
selecting a device with a greater converting capability from the third party terminal, the split type host and the third party player source, according to the first audio decoding parameter, the second audio decoding parameter and the third audio decoding parameter.

According to a second aspect, the present invention relates to a device for playing audio, the device including:a first acquiring module configured to acquire a first audio decoding parameter, the first audio decoding parameter being an audio decoding parameter of a third party terminal externally connected to a split type host, the first audio decoding parameter being used for describing a converting capability for converting a digital audio signal into an analog audio signal;
a comparison module configured to compare the first audio decoding parameter with the second audio decoding parameter and a selection module configured to select a device with a greater converting capability from the third party terminal and the split type host according to the first audio decoding parameter and a second audio decoding parameter, the second decoding parameter being an audio decoding parameter of the split type host; anda playing module configured to play the audio using the selected device,wherein both the first and second audio decoding parameters include at least a scheme for audio decoding.

According to a particular embodiment, the first and second audio decoding parameters further include at least one of a sampling frequency and a number of audio channel.

According to a particular embodiment, the selection module includes:a first determining unit configured to determine a first number and a second number, the first number being a number of the scheme for audio decoding included in the first audio decoding parameter, and the second number being a number of the scheme for audio decoding included in the second audio decoding parameter; a second determining unit configured to determine that the third party terminal is the device with a greater converting capability when the first number is greater than the second number; anda third determining unit configured to determine that the split type host is the device with a greater converting capability when the first number is smaller than the second number.

According to a particular embodiment, the selection module further includes:a first acquiring unit configured to acquire a first sampling frequency and a second sampling frequency, the first sampling frequency being a sampling frequency included in the first audio decoding parameter, and the second sampling frequency being a sampling frequency included in the second audio decoding parameter, when the first number equals to the second number and when the first and second audio decoding parameters further include a sampling frequency;a fourth determining unit configured to determine that the third party terminal is the device with a greater converting capability when the first sampling frequency is greater than the second sampling frequency; anda fifth determining unit configured to determine that the split type host is the device with a greater converting capability when the first sampling frequency is smaller than the second sampling frequency.

According to a particular embodiment, the selection module further includes:
a second acquiring unit configured to acquire a first number of audio channel and a second number of audio channel, the first number of audio channel being a number of audio channel included in the first audio decoding parameter, and the second number of audio channel being a number of audio channel included in the second audio decoding parameter, when the first number equals to the second number and when the first and second audio decoding parameters further include a number of audio channel;
a sixth determining unit configured to determine that the third party terminal is the device with a greater converting capability when the first number of audio channel is greater than the second number of audio channel; and
a seventh determining unit configured to determine that the split type host is the device with a greater converting capability when the first number of audio channel is smaller than the second number of audio channel.

According to a particular embodiment, the first acquiring module includes:
a reading unit configured to read an extended display identification data (EDID) of the third party terminal through a designated interface; and
a third acquiring unit configured to acquire the first audio decoding parameter from the EDID of the third party terminal.

According to a particular embodiment, the third acquiring unit includes:
a first acquiring subunit configured to acquire a data document from the EDID of the third party terminal according to a designated path; and
a second acquiring subunit configured to acquire the first audio decoding parameter from the data document.

According to a particular embodiment, the device includes:
a reading module configured to read an EDID of the split type host; and
a second acquiring module configured to acquire the second audio decoding parameter from the EDID of the split type host.

According to a particular embodiment, the selection module includes:
a fourth acquiring unit configured to acquire a third audio decoding parameter when the split type host is further externally connected to a third party player source having an audio playing function, the third audio decoding parameter being an audio decoding parameter of the third party player source; and
a selection unit configured to select a device with a greater converting capability from the third party terminal, the split type host and the third party player source, according to the first audio decoding parameter, the second audio decoding parameter and the third audio decoding parameter.

According a third aspect, the present invention relates to a device for playing audio, the device including:
a processor; and
a memory for storing instructions executable by the processor,
wherein the processor is configured to perform:
   acquiring a first audio decoding parameter, the first audio decoding parameter being an audio decoding parameter of a third party terminal externally connected to a split type host, the first audio decoding parameter being used for describing a converting capability for converting a digital audio signal into an analog audio signal;
   selecting a device with a greater converting capability from the third party terminal and the split type host according to the first audio decoding parameter and a second audio decoding parameter, the second decoding parameter being an audio decoding parameter of the split type host; and
   playing the audio using the selected device,
wherein both the first and second audio decoding parameters include at least a scheme for audio decoding.

In one particular embodiment, the steps of the method for playing audio are determined by computer program instructions.

Consequently, according to a fourth aspect, the present invention is also directed to a computer program for executing the steps of a method for playing audio as described above when this program is executed by a computer.

This program can use any programming language and take the form of source code, object code or a code intermediate between source code and object code, such as a partially compiled form, or any other desirable form.

The invention is also directed to a computer-readable information medium containing instructions of a computer program as described above.

The information medium can be any entity or device capable of storing the program. For example, the information medium can include storage means such as a ROM, for example a CD ROM or a microelectronic circuit ROM, or magnetic storage means, for example a diskette (floppy disk) or a hard disk.

Alternatively, the information medium can be an integrated circuit in which the program is incorporated, the circuit being adapted to execute the method in question or to be used in its execution.

According to the technical solutions of the present invention, the following advantageous effects may be provided. In the embodiments of the present invention, as both the split type host and the third party terminal may play audio and may have different playing effects, it is possible to compare the first audio decoding parameter with the second audio decoding parameter, so as to select a device with a greater converting capability as the device for playing audio, thereby improving an audio playing effect and an accuracy of device selection.

It is to be understood that both the foregoing general description and the following detailed description are exemplary and explanatory only and are not restrictive of the present invention.

### BRIEF DESCRIPTION OF THE DRAWINGS

The accompanying drawings, which are incorporated in and constitute a part of this specification, illustrate embodiments consistent with the present invention and, together with the description, serve to explain the principles of the present invention.
Fig. 1 is a schematic diagram illustrating a configuration of the system for playing audio according to an exemplary embodiment.
Fig. 2 is a schematic diagram illustrating another configuration of the system for playing audio according to an exemplary embodiment.
Fig. 3 is a flow chart illustrating a method for playing audio according to an exemplary embodiment.
Fig. 4 is a flow chart illustrating another method for playing audio according to an exemplary embodiment.
Fig. 5 is a block diagram illustrating a device for playing audio according to an exemplary embodiment.
Fig. 6 is a block diagram illustrating a selection module according to an exemplary embodiment.
Fig. 7 is a block diagram illustrating another selection module according to an exemplary embodiment.
Fig. 8 is a block diagram illustrating another selection module according to an exemplary embodiment.
Fig. 9 is a block diagram illustrating a first acquiring module according to an exemplary embodiment.
Fig 10 is a block diagram illustrating a third acquiring unit according to an exemplary embodiment.
Fig. 11 is a block diagram illustrating another device for playing audio according to an exemplary embodiment.
Fig. 12 is a block diagram illustrating another selection module according to an exemplary embodiment.
Fig. 13 is a block diagram illustrating another device for playing audio according to an exemplary embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the present invention. Instead, they are merely examples of devices and methods consistent with aspects related to the present invention as recited in the appended claims.

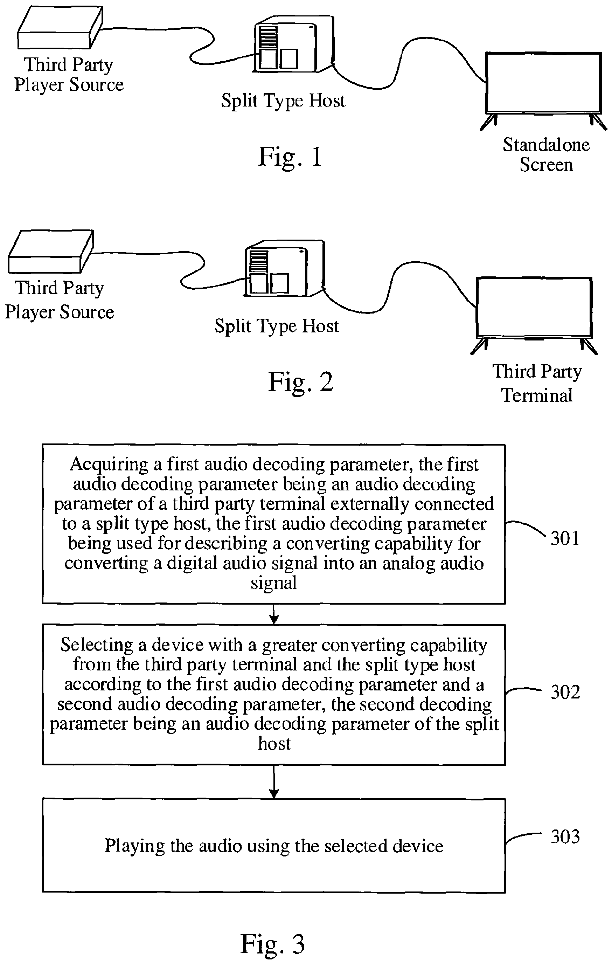

Before describing the embodiments of the present invention in detail, a system architecture according to embodiments of the present invention will be introduced firstly. As illustrated in Fig. 1, the system includes a split type host and a standalone screen. The split type host may be connected to the standalone screen through a high definition multimedia interface (HDMI). The split type host may be configured to process signals and play audio information, and the standalone screen is configured to display an image. In addition to being connected to the standalone screen, the split type host may be further externally connected to a third party player source, which is a device for providing a video source or an audio source. The third party player source may be a player source with or without an audio playing function. Further, in addition to being connected to the standalone screen through the HDMI, the split type host may be further externally connected to the third party terminal through the HIMI. Referring to Fig. 2, a third party terminal may perform both image displaying and audio playing, and the split type host may be further externally connected to a third party player source in addition to being externally connected to the third party terminal.

Based on the above Fig. 1, when the split type host is connected to the standalone screen and the third party player source, the standalone screen is used to display images, and the split type host may be used to play audio. In the case where the third party player source has a function for playing audio, the third party player source may also be used to play audio. Accordingly, the system includes two devices having audio playing function. Based on the above Fig. 2, when the split type host is connected to the third party terminal and the third party player source, both the split type host and third party terminal may be used to play audio. In the case where the third party player source has a function for playing audio, the third party player source may also be used to play audio. Accordingly, the system includes three devices having audio playing function. Generally, audio information is required to be played by only one device, and thus embodiments of the present invention provide a method for playing audio information, such that one device may be selected from a plurality of devices having audio playing function to play the audio.

Fig. 3 is a flowchart illustrating a method for playing audio according to an exemplary embodiment of the present invention. As illustrated in Fig. 3, the method for playing audio is applicable in a terminal. The method includes the steps as follows.

In step S301, a first audio decoding parameter is acquired. The first audio decoding parameter is an audio decoding parameter of the third party terminal externally connected to the split type host, and the first audio decoding parameter is used for describing a converting capability for converting a digital audio signal into an analog audio signal.

In step 302, a device with a greater converting capability is selected from third party terminal and the split type host according to the first audio decoding parameter and a second audio decoding parameter. The second decoding parameter is an audio decoding parameter of the split type host.

In step 303, the audio is played using the selected device.

In the present embodiment, both the first and second audio decoding parameters include at least a scheme for audio decoding.

In the embodiments of the present invention, as both the split type host and the third party terminal may play audio and may have different playing effects, it is possible to compare the first audio decoding parameter with the second audio decoding parameter, so as to select a device with a greater converting capability as the device for playing audio, thereby improving an audio playing effect and an accuracy of device selection.

In another embodiment of the present invention, the first and second audio decoding parameters may further include at least one of a sampling frequency and a number of audio channel.

In another embodiment of the present invention, the step of selecting a device with a greater converting capability from the third party terminal and the split type host according to the first audio decoding parameter and a second audio decoding parameter includes the steps as follows.

A first number and a second number are determined. The first number is a number of the scheme for audio decoding included in the first audio decoding parameter, and the second number is a number of the scheme for audio decoding included in the second audio decoding parameter.

When the first number is greater than the second number, it is determined that the third party terminal is the device with a greater converting capability.

When the first number is smaller than the second number, it is determined that the split type host is the device with a greater converting capability.

In another embodiment of the present invention, after the step of determining the first number and the second number, the method may further include the steps as follows.

When the first number equals to the second number and when the first and second audio decoding parameters further include a sampling frequency, a first sampling frequency and a second sampling frequency are acquired. The first sampling frequency is a sampling frequency included in the first audio decoding parameter, and the second sampling frequency is a sampling frequency included in the second audio decoding parameter.

When the first sampling frequency is greater than the second sampling frequency, it is determined that the third party terminal is the device with a greater converting capability.

When the first sampling frequency is smaller than the second sampling frequency, it is determined that the split type host is the device with a greater converting capability.

In another embodiment of the present invention, after the step of determining the first number and the second number, the method may further include the steps as follows.

When the first number equals to the second number and when the first and second audio decoding parameters further include a number of audio channel, a first number of audio channel and a second number of audio channel are acquired. The first number of audio channel is a number of audio channel included in the first audio decoding parameter, and the second number of audio channel is a number of audio channel included in the second audio decoding parameter.

When the first number of audio channel is greater than the second number of audio channel, it is determined that the third party terminal is the device with a greater converting capability.

When the first number of audio channel is smaller than the second number of audio channel, it is determined that the split type host is the device with a greater converting capability.

According to another embodiment of the present invention, the step of acquiring a first audio decoding parameter includes the steps as follows.

An extended display identification data (EDID) of the third party terminal is read through a designated interface.

The first audio decoding parameter is acquired from the EDID of the third party terminal.

According to another embodiment of the present invention, the step of acquiring the first audio decoding parameter from the EDID of the third party terminal includes the steps as follows.

A data document is acquired from the EDID of the third party terminal according to a designated path.

The first audio decoding parameter is acquired from the data document.

According to another embodiment of the present invention, before the step of selecting a device with a greater converting capability from the third party terminal and the split type host according to the first audio decoding parameter and a second audio decoding parameter, the method includes the step as follows.

An EDID of the split type host is read.

The second audio decoding parameter is acquired from the EDID of the split type host.

According to another embodiment of the present invention, the step of selecting a device with a greater converting capability from the third party terminal and the split type host according to the first audio decoding parameter and a second audio decoding parameter includes the steps as follows.

When the split type host is further externally connected to a third party player source having an audio playing function, a third audio decoding parameter is acquired. The third audio decoding parameter is an audio decoding parameter of the third party player source.

A device with a greater converting capability is selected from the third party terminal, the split type host and the third party player source, according to the first audio decoding parameter, the second audio decoding parameter and the third audio decoding parameter.

Further alternative embodiments of the present invention may be obtained by combining any of the above alternative technical solutions, which will not be described in detail herein.

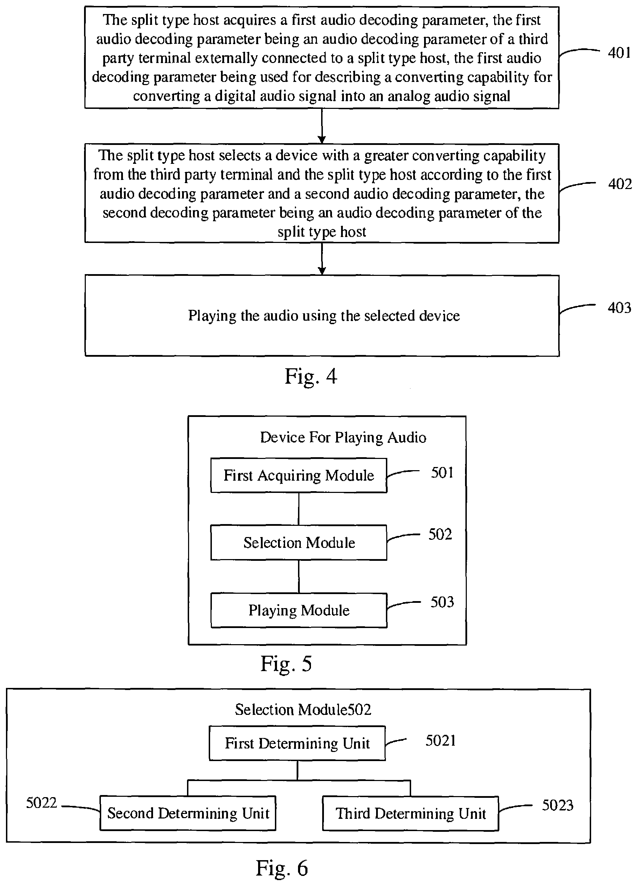

Fig. 4 is a flow chart illustrating another method for playing audio according to an exemplary embodiment. Referring to Fig. 4, the method includes the steps as follows.

In step 401, the split type host acquires a first audio decoding parameter. The first audio decoding parameter is an audio decoding parameter of a third party terminal externally connected to a split type host, and the first audio decoding parameter is used for describing a converting capability for converting a digital audio signal into an analog audio signal.

Both the third party terminal and the split type host may play audio, accordingly, in order to compare the audio play effect of the third party terminal with that of the split type host and select a device with better audio play effect from the third party terminal and the split type host, the split type host may acquire the first audio decoding parameter. The operation of the split type host to acquire the first audio decoding parameter may include: reading an EDID of the third party terminal from a designated interface; and acquiring the first audio decoding parameter from the EDID of the third party terminal.

In one embodiment, an operation for the split type host to acquire the first audio decoding parameter from the EDID of the third party terminal may include: acquiring a data document from the EDID of the third party terminal according to a designated path; and acquiring the first audio decoding parameter from the data document.

It should be noted that the designated path is a path for acquiring the data document from the EDID, and the designated path may be configured in advance since the data document is generally positioned in a fixed position in the EDID. However, the present invention is not limited thereto.

In addition, the data document may refer to a document including information regarding the audio configuration in the EDID. For example, the data document may be a Consumer Electronics Association-861 (CEA-861) document, that is, an uncompressed digital video standard developed by the CEA. However, the present invention is not limited thereto.

Further, when the split type host acquires the data document of the third party terminal, the split type host may acquire the corresponding audio decoding parameter from the data document based on an audio decoding parameter identifier, and determines the acquired audio decoding parameter as the first audio decoding parameter.

It should be noted that the audio decoding parameter identifier is used to identify the audio decoding parameter uniquely. The audio decoding parameter identifier may be, for example, a name of the audio decoding parameter. Optionally, the audio decoding parameter identifier may be a constant number of the audio decoding parameter, or other identifiers, which is not limited in the embodiments of the present invention.

For example, when the designated path is EDID->CEA BLOCK->DATA BLOCK, the split type host may acquire the data document of "DATA BLOCK" according to the designated path. In the case where the audio decoding parameter identifier is "Audio", the split type host may acquire the audio decoding parameter corresponding to the "Audio" from the "DATA BLOCK" according to the audio decoding parameter identifier "Audio", and determine the acquired audio decoding parameter as the first audio decoding parameter.

Further, the designated interface may be configured to acquire the EDID of the third party terminal. The designated interface may be an HDMI or other interfaces, which is not limited in the embodiments of the present invention.

It should be noted that the first audio decoding parameter includes at least a scheme for audio decoding. The scheme for audio decoding refers to the scheme for decoding audio information in the third party terminal. The scheme for audio decoding may include a pulse code modulation (PCM), an audio coding 3 (AC3), a digital theater system (DTS), a linear predictive coding (LPC) or the like. However, embodiments of the present invention are not limited thereto.

It should be noted that when the split type host is externally connected to the standalone screen, the split type host will not require the designated interface to obtain the first audio decoding parameter as the standalone screen does not include an audio playing function. However, when the split type host is externally connected to the third party terminal, the split type host may acquire the first audio decoding parameter through the designated interface as the third party terminal includes an audio playing function.

Further, in addition to the scheme for audio decoding, the first audio decoding parameter may further include at least one of a sampling frequency and a number of audio channel. The first audio decoding parameter may also include other parameters such as a number of bits of the audio, which is not limited in the embodiments of the present invention.

In step 402, the split type host selects a device with a greater converting capability from the third party terminal and the split type host according to the first audio decoding parameter and a second audio decoding parameter. The second decoding parameter is an audio decoding parameter of the split type host.

The converting capability may indicate the capability for converting a digital audio signal into an analog audio signal, and thus when the device has a greater converting capability, the device may have a better audio playing effect when playing audio. Accordingly, in order to achieve a better audio playing effect, the split type host may select a device with a greater converting capability from the third party terminal and the split type host according to the first audio decoding parameter and a second audio decoding parameter. The first audio coding parameter and the second audio coding parameter include at least a scheme for audio decoding, and thus the operation of the split type host to select a device with a greater converting capability from the third party terminal and the split type host according to the first audio decoding parameter and a second audio decoding parameter may include: determining a first number and a second number, the first number being a number of the scheme for audio decoding included in the first audio decoding parameter, and the second number being a number of the scheme for audio decoding included in the second audio decoding parameter; determining that the third party terminal is the device with a greater converting capability when the first number is greater than the second number; and determining that the split type host is the device with a greater converting capability when the first number is smaller than the second number.

For example, when the scheme for audio decoding included in the first audio decoding parameter is a PCL, an AC3 and a DTS, the first number is three (3); and when the scheme for audio decoding included in the second audio decoding parameter is a PCL and a DTS, the second number is two (2). In this case, the first number (three) is greater than the second number (two), and thus the third party terminal is determined as the device with a greater converting capability.

It should be noted that, in addition to the scheme for audio decoding, the second audio decoding parameter may further include at least one of a sampling frequency and a number of audio channel. The second audio decoding parameter may also include other parameters such as a number of bits of the audio, which is not limited in the embodiments of the present invention.

In addition, when the first number equals to the second number, and when the first and second audio decoding parameters further include a sampling frequency, a first sampling frequency and a second sampling frequency are acquired. The first sampling frequency is a sampling frequency included in the first audio decoding parameter, and the second sampling frequency is a sampling frequency included in the second audio decoding parameter. When the first sampling frequency is greater than the second sampling frequency, the third party terminal is determined as the device with a greater converting capability. When the first sampling frequency is smaller than the second sampling frequency, the split type host is determined as the device with a greater converting capability.

It should be noted that the sampling frequency refers to a number of audio samples per second, which may be 32 KHz, 48 KHz, 96 KHz or the like. Embodiments of the present invention are not limited thereto.

The greater the sampling frequency of the device is, the better the audio playing effect of the audio information may become. Accordingly, the device having a greater sampling frequency may be determined as the device with a greater converting capability.

Similarly, when the first number equals to the second number, and when the first and second audio decoding parameters further include a number of audio channel, a first number of audio channel and a second number of audio channel are acquired. The first number of audio channel is a number of audio channel included in the first audio decoding parameter, and the second number of audio channel is a number of audio channel included in the second audio decoding parameter. When the first number of audio channel is greater than the second number of audio channel, the third party terminal is determined as the device with a greater converting capability. When the first number of audio channel is smaller than the second number of audio channel, the split type host is determined as the device with a greater converting capability.

It should be noted that the number of audio channel is a number of the audio channel(s) that may be supported by the device, which may be a single-channel, a 4-channel, a 5-channel, or the like. Embodiments of the present invention are not limited thereto.

In the case where the device has more audio channels, the device may have a greater signal-noise ratio, which may in turn generate less noise, thereby having a better audio playing effect when playing audio information. Accordingly, the device having more audio channels may be determined as the device with a greater converting capability.

Similarly, when the first number equals to the second number, and when the first and second audio decoding parameters further include the sampling frequency and the number of audio channel, the first sampling frequency and the second sampling frequency are acquired. When the first sampling frequency is greater than the second sampling frequency, the third party terminal is determined as the device with a greater converting capability. When the first sampling frequency is smaller than the second sampling frequency, the split type host is determined as the device with a greater converting capability. When the first sampling frequency equals to the second sampling frequency, the first number of audio channel and the second number of audio channel are further acquired. When the first number of audio channel is greater than the second number of audio channel, the third party terminal is determined as the device with a greater converting capability. When the first number of audio channel is smaller than the second number of audio channel, the split type host is determined as the device with a greater converting capability.

Obviously, when the first and second audio decoding parameters further include the sampling frequency and the number of audio channel, it is possible to firstly acquire the first number of audio channel and the second number of audio channel. When the first number of audio channel is greater than the second number of audio channel, the third party terminal is determined as the device with a greater converting capability. When the first number of audio channel is smaller than the second number of audio channel, the split type host is determined as the device with a greater converting capability. When the first number of audio channel equals to the second number of audio channel, the first sampling frequency and the second sampling frequency are further acquired. When the first sampling frequency is greater than the second sampling frequency, the third party terminal is determined as the device with a greater converting capability. When the first sampling frequency is smaller than the second sampling frequency, the split type host is determined as the device with a greater converting capability. Embodiments of the present invention are not limited thereto.

Further, when the first number equals to the second number, and when the first audio decoding parameter and the second audio decoding parameter include only the scheme for audio decoding, the split type host may select the device with a greater converting capability according to a first decoding order. The first decoding order may be determined by sorting all the schemes for audio decoding that may be used to decode audio information, according to the decoding effect thereof.

In one embodiment, when the split type host acquires the first audio decoding parameter and the second audio decoding parameter, and when the first decoding order is pre-stored in the split type host, the split type host may determine a sort position in the first decoding order of the scheme for audio decoding included in the first audio decoding parameter, and determine a sort position in the first decoding order of the scheme for audio decoding included in the second audio decoding parameter. When the first decoding order is sorted in an order from a better decoding effect to a poorer decoding effect, the device having the scheme for audio decoding with the headmost sort order may be determined as the device with a greater converting capability. When the first decoding order is sorted in an order from a poorer decoding effect to a better decoding effect, the device having the scheme for audio decoding with the last sort order may be determined as the device with a greater converting capability. However, if one or some scheme(s) for audio decoding is(are) included both in the first audio decoding parameter and the second audio decoding parameter, the split type host may acquire other schemes for audio decoding that are included either in the first audio decoding parameter or the second audio decoding parameter. When the first decoding order is sorted in an order from a better decoding effect to a poorer decoding effect, the device having the scheme for audio decoding with the headmost sort order among the different schemes for audio decoding may be determined as the device with a greater converting capability. When the first decoding order is sorted in an order from a poorer decoding effect to a better decoding effect, the device having the scheme for audio decoding with the last sort order among the different schemes for audio decoding may be determined as the device with a greater converting capability.

Further, when the first decoding order is pre-stored in the split type host, the split type host may not only select the device with a greater converting capability based on the above method, but also may compare the schemes for audio decoding included in the first audio decoding parameter and the schemes for audio decoding included in the second decoding parameter one by one according to the first decoding order. As the first decoding order is determined by sorting all the schemes for audio decoding that may be used to decode audio information according to the decoding effect thereof, the device having the scheme for audio decoding with the best audio decoding effect may be determined as the device with a greater converting capability. Similarly, if one or some scheme(s) for audio decoding is(are) included both in the first audio decoding parameter and the second audio decoding parameter, the split type host may acquire other schemes for audio decoding that are included either in the first audio decoding parameter or the second audio decoding parameter, and the device having the scheme for audio decoding with the best audio decoding effect may be determined as the device with a greater converting capability.

For example, when the first decoding order is sorted in an order from a better decoding effect to a poorer decoding effect and the first decoding order stored in the split type host is DTS, AC3, PCM, and LPC. The schemes for audio decoding included in the first audio decoding parameter are PCM and AC3, and the schemes for audio decoding included in the second audio decoding parameter are PCM and LPC. As both the first audio decoding parameter and the second audio decoding parameter include the scheme for audio decoding of PCM, the split type host may only compare the scheme for audio decoding of AC3 and the scheme for audio decoding of PCL according to the first decoding order. It may be determined that the AC3 may have a decoding effect better than that of the PCL, and thus the third party terminal may be determined as the device with a greater converting capability.

Optionally, the split type host may also sort the schemes for audio decoding included in the first audio decoding parameter and the schemes for audio decoding included in the second audio decoding parameter directly based on the decoding effect thereof, to obtain a second decoding order. Afterwards, the split type host may determine the device having the scheme for audio decoding with the best audio decoding effect as the device with a greater converting capability based on the second decoding order. Similarly, if one or some scheme(s) for audio decoding is(are) included both in the first audio decoding parameter and the second audio decoding parameter, the split type host may acquire other schemes for audio decoding that are included either in the first audio decoding parameter or the second audio decoding parameter, and may sort the different schemes for audio decoding based on the decoding effect thereof. Accordingly, the device having the scheme for audio decoding with the best audio decoding effect may be determined as the device with a greater converting capability.

It should be noted that the first decoding order may be pre-stored in the split type host, which is not limited in the embodiments of the present invention.

Further, in the first decoding order, the schemes for audio decoding may be sorted in in an order from a better decoding effect to a poorer decoding effect, or may be sorted in an order from a poorer decoding effect to a better decoding effect, which is not limited in the embodiments of the present invention. Likewise, in the second decoding order, the schemes for audio decoding may be sorted in in an order from a better decoding effect to a poorer decoding effect, or may be sorted in an order from a poorer decoding effect to a better decoding effect, which is not limited in the embodiments of the present invention.

It should be noted that, the split type host may determine the quality of the decoding effect according to a required bandwidth of the scheme for audio decoding, thereby sorting the scheme for audio decoding according to the decoding effect thereof. However, the split type host may sort the scheme for audio decoding according to the quality of the decoding effect determined according to other ways, which is not limited in the embodiments of the present invention.

In addition, when the split type host and the third party terminal have the same converting capability, the split type host may select a device randomly from the split type host and the third party terminal, which is not limited in the embodiments of the present invention.

Further, before selecting the device with a greater converting capability from the third party terminal and the split type host according to the first audio decoding parameter and a second audio decoding parameter, the split type host may further read the EDID of the split type host and acquire the second audio decoding parameter from the EDID of the split type host.

In one embodiment, manners for the split type host to obtain the second audio decoding parameter from the EDID of the split type host may refer to the manners for the split type host to obtain the first audio decoding parameter, which will not be repeated herein.

In step 403, the audio may be played using the selected device.

In addition to being externally connected to the third party terminal, the split type host may be further externally connected to a third party player source, and thus when the third party player source externally connected to the split type host also has an audio playing function, the split type host may further acquire a third audio decoding parameter. The third audio decoding parameter is an audio decoding parameter of the third party player source. A device with a greater converting capability may be selected from the third party terminal, the split type host and the third party player source, according to the first audio decoding parameter, the second audio decoding parameter and the third audio decoding parameter.

In one embodiment, operation for the split type host to acquire the third audio decoding parameter may refer to the operation for the split type host to acquire the first audio decoding parameter, which will not be repeated herein.

Further, the method for the split type host to select the device with a greater converting capability from the third party terminal, the split type host and the third party player source, according to the first audio decoding parameter, the second audio decoding parameter and the third audio decoding parameter may refer to the above step 402, which will not be repeated herein.

It should be noted that the third party player source may refer to a player source of the audio information, and the third party player source may be a disc player, an audio player or the like, which is not limited in the embodiments of the present invention.

Further, the split type host may be further externally connected to a plurality of devices having an audio playing function, and the split type host may compare the split type host with the plurality of devices on by one and select the device with the greatest converting capability to play the audio. That is, the split type host may select the device having the best playing effect to play the audio. Embodiments of the present invention are not limited thereto.

In the embodiments of the present invention, as both the split type host and the third party terminal may play audio and may have different playing effects, it is possible to compare the first audio decoding parameter with the second audio decoding parameter, so as to select a device with a greater converting capability as the device for playing audio, thereby improving an audio playing effect and an accuracy of device selection.

Fig. 5 is a block diagram illustrating a device for playing audio according to an exemplary embodiment. Referring to Fig. 5, the device may include a first acquiring module 501, a selection module 502 and a playing module 503.

The first acquiring module 501 is configured to acquire a first audio decoding parameter, wherein the first audio decoding parameter is an audio decoding parameter of a third party terminal externally connected to a split type host, and the first audio decoding parameter is used for describing a converting capability for converting a digital audio signal into an analog audio signal.

The selection module 502 is configured to select a device with a greater converting capability from the third party terminal and the split type host according to the first audio decoding parameter and a second audio decoding parameter, wherein the second decoding parameter is an audio decoding parameter of the split type host.

The playing module 503 is configured to play the audio using the selected device.

In one embodiment, both the first and second audio decoding parameters include at least a scheme for audio decoding.

In another embodiment of the present invention, the first and second audio decoding parameters further include at least one of a sampling frequency and a number of audio channel.

In another embodiment of the present invention, referring to Fig. 6, the selection module 502 includes a first determining unit 5021, a second determining unit 5022 and a third determining unit 5023.

The first determining unit 5021 is configured to determine a first number and a second number, wherein the first number is a number of the scheme for audio decoding included in the first audio decoding parameter, and the second number is a number of the scheme for audio decoding included in the second audio decoding parameter.

The second determining unit 5022 is configured to determine that the third party terminal is the device with a greater converting capability when the first number is greater than the second number.

The third determining unit 5023 is configured to determine that the split type host is the device with a greater converting capability when the first number is smaller than the second number.

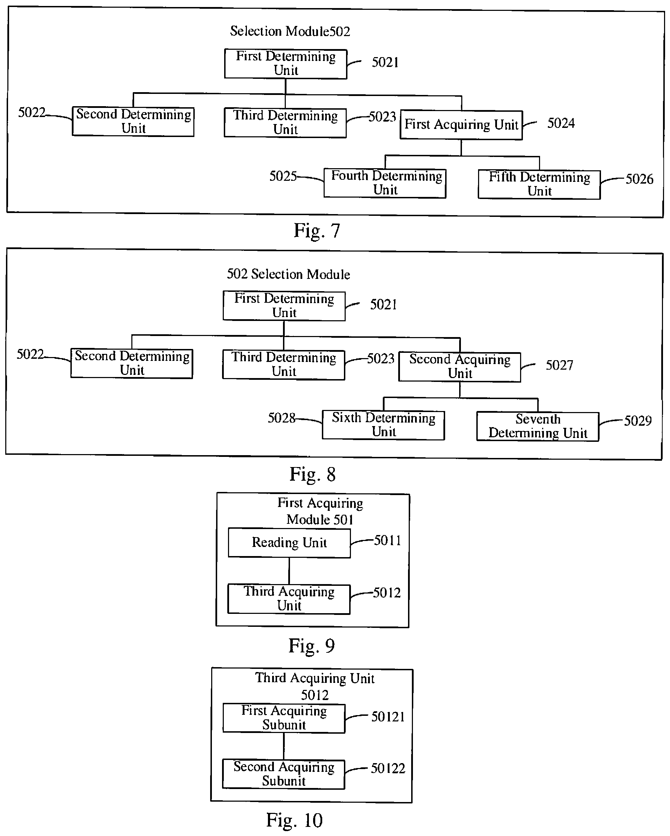

In another embodiment of the present invention, referring to Fig. 7, the selection module 502 further includes a first acquiring unit 5024, a fourth determining unit 5025 and a fifth determining unit 5026.

The first acquiring unit 5024 is configured to acquire a first sampling frequency and a second sampling frequency, wherein the first sampling frequency is a sampling frequency included in the first audio decoding parameter, and the second sampling frequency is a sampling frequency included in the second audio decoding parameter, when the first number equals to the second number and when the first and second audio decoding parameters further include a sampling frequency.

The fourth determining unit 5025 is configured to determine that the third party terminal is the device with a greater converting capability when the first sampling frequency is greater than the second sampling frequency; and

The fifth determining unit 5026 is configured to determine that the split type host is the device with a greater converting capability when the first sampling frequency is smaller than the second sampling frequency.

In another embodiment of the present invention, referring to Fig. 8, the selection module further includes a second acquiring unit 5027, a sixth determining unit 5028 and a seventh determining unit 5029.

The second acquiring unit 5027 is configured to acquire a first number of audio channel and a second number of audio channel, wherein the first number of audio channel is a number of audio channel included in the first audio decoding parameter, and the second number of audio channel is a number of audio channel included in the second audio decoding parameter, when the first number equals to the second number and when the first and second audio decoding parameters further include a number of audio channel.

The sixth determining unit 5028 is configured to determine that the third party terminal is the device with a greater converting capability when the first number of audio channel is greater than the second number of audio channel.

The seventh determining unit 5029 is configured to determine that the split type host is the device with a greater converting capability when the first number of audio channel is smaller than the second number of audio channel.

In another embodiment of the present invention, referring to Fig. 9, the first acquiring module 501 includes a reading unit 5011 and a third acquiring unit 5012.

The reading unit 5011 is configured to read an extended display identification data (EDID) of the third party terminal through a designated interface.

The third acquiring unit 5012 is configured to acquire the first audio decoding parameter from the EDID of the third party terminal.

In another embodiment of the present invention, referring to Fig. 10, third acquiring unit 5012 includes a first acquiring subunit 50121 and a second acquiring subunit 50122.

The first acquiring subunit 50121 is configured to acquire a data document from the EDID of the third party terminal according to a designated path.

The second acquiring subunit 50122 is configured to acquire the first audio decoding parameter from the data document.

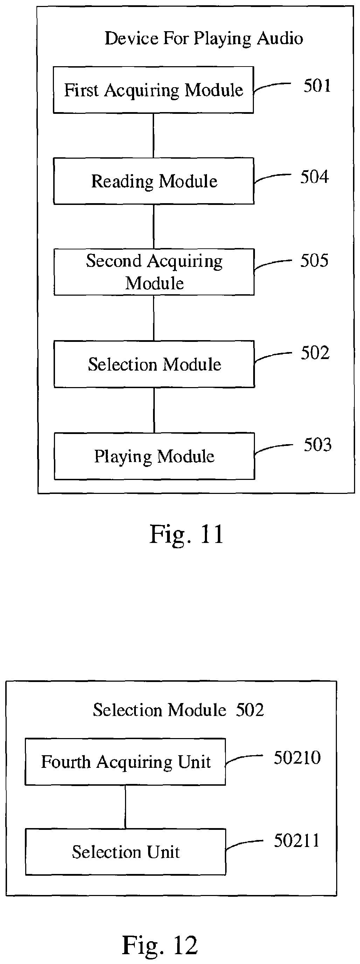

According to another embodiment of the present invention, referring to Fig. 11, the device includes a reading module 504 and a second acquiring module 505.

The reading module 504 is configured to read an EDID of the split type host.

The second acquiring module 505 is configured to acquire the second audio decoding parameter from the EDID of the split type host.

According to another embodiment of the present invention, referring to Fig. 12, the selection module 502 includes a fourth acquiring unit 50210 and a selection unit 50211.

The fourth acquiring unit 50210 is configured to acquire a third audio decoding parameter when the split type host is further externally connected to a third party player source having an audio playing function, wherein the third audio decoding parameter is an audio decoding parameter of the third party player source.

The selection unit 50211 is configured to select a device with a greater converting capability from the third party terminal, the split type host and the third party player source, according to the first audio decoding parameter, the second audio decoding parameter and the third audio decoding parameter.

In the embodiments of the present invention, as both the split type host and the third party terminal may play audio and may have different playing effects, it is possible to compare the first audio decoding parameter with the second audio decoding parameter, so as to select a device with a greater converting capability as the device for playing audio, thereby improving an audio playing effect and an accuracy of device selection.

With respect to the devices in the above embodiments, the specific manners for performing operations for individual modules therein have been described in detail in the embodiments regarding the methods, which will not be elaborated herein.

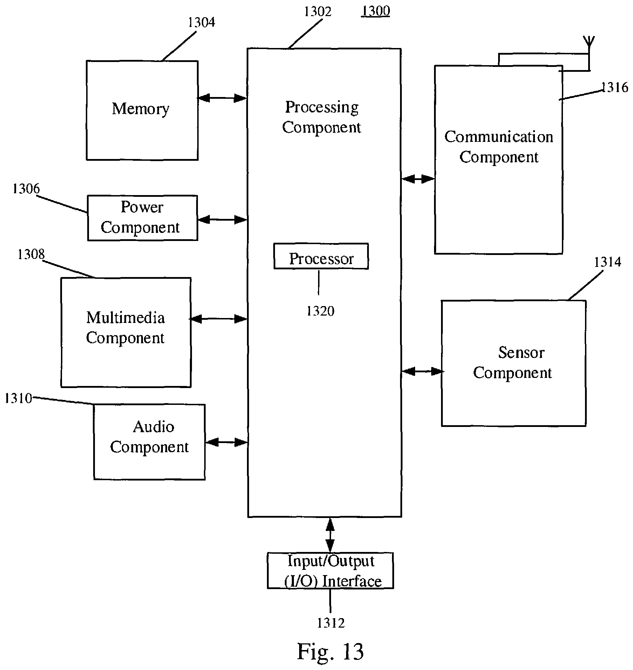

Fig. 13 is a block diagram of a device 1300 for playing audio, according to an exemplary embodiment. For example, the device 1300 may be a mobile phone, a computer, a digital broadcast terminal, a messaging device, a gaming console, a tablet, a medical device, exercise equipment, a personal digital assistant, and the like.

Referring to Fig. 13, the device 1300 may include one or more of the following components: a processing component 1302, a memory 1304, a power component 1306, a multimedia component 1308, an audio component 1310, an input/output (I/O) interface 1312, a sensor component 1314, and a communication component 1316.

The processing component 1302 typically controls overall operations of the device 1300, such as the operations associated with display, telephone calls, data communications, camera operations, and recording operations. The processing component 1302 may include one or more processors 1320 to execute instructions to perform all or part of the steps in the above described methods. Moreover, the processing component 1302 may include one or more modules which facilitate the interaction between the processing component 1302 and other components. For instance, the processing component 1302 may include a multimedia module to facilitate the interaction between the multimedia component 1308 and the processing component 1302.

The memory 1304 is configured to store various types of data to support the operation of the device 1300. Examples of such data include instructions for any applications or methods operated on the device 1300, contact data, phonebook data, messages, pictures, video, etc. The memory 1304 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 1306 provides power to various components of the device 1300. The power component 1306 may include a power management system, one or more power sources, and any other components associated with the generation, management, and distribution of power in the device 1300.

The multimedia component 1308 includes a screen providing an output interface between the device 1300 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some embodiments, the multimedia component 1308 includes a front camera and/or a rear camera. The front camera and the rear camera may receive an external multimedia datum while the device 1300 is in an operation mode, such as a photographing mode or a video mode. Each of the front camera and the rear camera may be a fixed optical lens system or have focus and optical zoom capability.

The audio component 1310 is configured to output and/or input audio signals. For example, the audio component 1310 includes a microphone ("MIC") configured to receive an external audio signal when the device 1300 is in an operation mode, such as a call mode, a recording mode, and a voice recognition mode. The received audio signal may be further stored in the memory 1304 or transmitted via the communication component 1316. In some embodiments, the audio component 1310 further includes a speaker to output audio signals.

The I/O interface 1312 provides an interface between the processing component 1302 and peripheral interface modules, such as a keyboard, a click wheel, buttons, and the like. The buttons may include, but are not limited to, a home button, a volume button, a starting button, and a locking button.

The sensor component 1314 includes one or more sensors to provide status assessments of various aspects of the device 1300. For instance, the sensor component 1314 may detect an open/closed status of the device 1300, relative positioning of components, e.g., the display and the keypad, of the device 1300, a change in position of the device 1300 or a component of the device 1300, a presence or absence of user contact with the device 1300, an orientation or an acceleration/deceleration of the device 1300, and a change in temperature of the device 1300. The sensor component 1314 may include a proximity sensor configured to detect the presence of nearby objects without any physical contact. The sensor component 1314 may also include a light sensor, such as a CMOS or CCD image sensor, for use in imaging applications. In some embodiments, the sensor component 1314 may also include an accelerometer sensor, a gyroscope sensor, a magnetic sensor, a pressure sensor, or a temperature sensor.

The communication component 1316 is configured to facilitate communication, wired or wirelessly, between the device 1300 and other devices. The device 1300 can access a wireless network based on a communication standard, such as WiFi, 2G, or 3G, or a combination thereof. In one exemplary embodiment, the communication component 1316 receives a broadcast signal or broadcast associated information from an external broadcast management system via a broadcast channel. In one exemplary embodiment, the communication component 1316 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, and other technologies.

In exemplary embodiments, the device 1300 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the above described methods.

In exemplary embodiments, there is also provided a non-transitory computer-readable storage medium including instructions, such as included in the memory 1304, executable by the processor 1320 in the device 1300, for performing the above-described methods. For example, the non-transitory computer-readable storage medium may be a ROM, a RAM, a CD-ROM, a magnetic tape, a floppy disc, an optical data storage device, and the like.

A non-transitory computer-readable storage medium storing instructions, when being executed by a processor in a mobile terminal, causes the mobile terminal to be able to perform a method for playing audio. The method includes the steps as follows.

A first audio decoding parameter is acquired. The first audio decoding parameter is an audio decoding parameter of the third party terminal externally connected to the split type host, and the first audio decoding parameter is used for describing a converting capability for converting a digital audio signal into an analog audio signal.

A device with a greater converting capability is selected from third party terminal and the split type host according to the first audio decoding parameter and a second audio decoding parameter. The second decoding parameter is an audio decoding parameter of the split type host.

The audio is played using the selected device.

In the present embodiment, both the first and second audio decoding parameters include at least a scheme for audio decoding.

In another embodiment of the present invention, the first and second audio decoding parameters may further include at least one of a sampling frequency and a number of audio channel.

In another embodiment of the present invention, the step of selecting a device with a greater converting capability from the third party terminal and the split type host according to the first audio decoding parameter and a second audio decoding parameter includes the steps as follows.

A first number and a second number are determined. The first number is a number of the scheme for audio decoding included in the first audio decoding parameter, and the second number is a number of the scheme for audio decoding included in the second audio decoding parameter.

When the first number is greater than the second number, it is determined that the third party terminal is the device with a greater converting capability.

When the first number is smaller than the second number, it is determined that the split type host is the device with a greater converting capability.

In another embodiment of the present invention, after the step of determining the first number and the second number, the method may further include the steps as follows.

When the first number equals to the second number and when the first and second audio decoding parameters further include a sampling frequency, a first sampling frequency and a second sampling frequency are acquired. The first sampling frequency is a sampling frequency included in the first audio decoding parameter, and the second sampling frequency is a sampling frequency included in the second audio decoding parameter.

When the first sampling frequency is greater than the second sampling frequency, it is determined that the third party terminal is the device with a greater converting capability.

When the first sampling frequency is smaller than the second sampling frequency, it is determined that the split type host is the device with a greater converting capability.

In another embodiment of the present invention, after the step of determining the first number and the second number, the method may further include the steps as follows.

When the first number equals to the second number and when the first and second audio decoding parameters further include a number of audio channel, a first number of audio channel and a second number of audio channel are acquired. The first number of audio channel is a number of audio channel included in the first audio decoding parameter, and the second number of audio channel is a number of audio channel included in the second audio decoding parameter.

When the first number of audio channel is greater than the second number of audio channel, it is determined that the third party terminal is the device with a greater converting capability.

When the first number of audio channel is smaller than the second number of audio channel, it is determined that the split type host is the device with a greater converting capability.

According to another embodiment of the present invention, the step of acquiring a first audio decoding parameter includes the steps as follows.

An extended display identification data (EDID) of the third party terminal is read through a designated interface.

The first audio decoding parameter is acquired from the EDID of the third party terminal.

According to another embodiment of the present invention, the step of acquiring the first audio decoding parameter from the EDID of the third party terminal includes the steps as follows.

A data document is acquired from the EDID of the third party terminal according to a designated path.

The first audio decoding parameter is acquired from the data document.

According to another embodiment of the present invention, before the step of selecting a device with a greater converting capability from the third party terminal and the split type host according to the first audio decoding parameter and a second audio decoding parameter, the method includes the step as follows.

An EDID of the split type host is read.

The second audio decoding parameter is acquired from the EDID of the split type host.

According to another embodiment of the present invention, the step of selecting a device with a greater converting capability from the third party terminal and the split type host according to the first audio decoding parameter and a second audio decoding parameter includes the steps as follows.

When the split type host is further externally connected to a third party player source having an audio playing function, a third audio decoding parameter is acquired. The third audio decoding parameter is an audio decoding parameter of the third party player source.

A device with a greater converting capability is selected from the third party terminal, the split type host and the third party player source, according to the first audio decoding parameter, the second audio decoding parameter and the third audio decoding parameter.

In the embodiments of the present invention, as both the split type host and the third party terminal may play audio and may have different playing effects, it is possible to compare the first audio decoding parameter with the second audio decoding parameter, so as to select a device with a greater converting capability as the device for playing audio, thereby improving an audio playing effect and an accuracy of device selection.

## Claims

1. A method for playing audio, **characterized in that** the method comprises:
acquiring (301) a first audio decoding parameter, the first audio decoding parameter being an audio decoding parameter of a third party terminal externally connected to a split type host, the first audio decoding parameter being used for describing a converting capability for converting a digital audio signal into an analog audio signal;
comparing the first audio decoding parameter with the second audio decoding parameter and selecting (302) a device with a greater converting capability from the third party terminal and the split type host according to the first audio decoding parameter and a second audio decoding parameter, the second decoding parameter being an audio decoding parameter of the split type host; and
playing (303) the audio using the selected device,
wherein both the first audio decoding parameter and the second audio decoding parameter comprise at least a scheme for audio decoding.

2. The method according to claim 1, wherein the first audio decoding parameter and the second audio decoding parameter further comprise at least one of a sampling frequency and a number of audio channel.

3. The method according to claim 1, wherein the step of selecting (302) a device with a greater converting capability from the third party terminal and the split type host according to the first audio decoding parameter and a second audio decoding parameter comprises:
determining a first number and a second number, the first number being a number of the scheme for audio decoding included in the first audio decoding parameter, and the second number being a number of the scheme for audio decoding included in the second audio decoding parameter;
determining that the third party terminal is the device with a greater converting capability when the first number is greater than the second number; and
determining that the split type host is the device with a greater converting capability when the first number is smaller than the second number.

4. The method according to claim 3, wherein after the step of determining a first number and a second number, the method further comprises:
when the first number equals to the second number and when the first audio decoding parameter and the second audio decoding parameter further comprise a sampling frequency, acquiring a first sampling frequency and a second sampling frequency, the first sampling frequency being a sampling frequency included in the first audio decoding parameter, and the second sampling frequency being a sampling frequency included in the second audio decoding parameter;
determining that the third party terminal is the device with a greater converting capability when the first sampling frequency is greater than the second sampling frequency; and
determining that the split type host is the device with a greater converting capability when the first sampling frequency is smaller than the second sampling frequency.

5. The method according to claim 3, wherein after the step of determining a first number and a second number, the method further comprises:
when the first number equals to the second number and when the first audio decoding parameter and the second audio decoding parameter further comprise a number of audio channel, acquiring a first number of audio channel and a second number of audio channel, the first number of audio channel being a number of audio channel included in the first audio decoding parameter, and the second number of audio channel being a number of audio channel included in the second audio decoding parameter;
determining that the third party terminal is the device with a greater converting capability when the first number of audio channel is greater than the second number of audio channel; and
determining that the split type host is the device with a greater converting capability when the first number of audio channel is smaller than the second number of audio channel.

6. The method according to anyone of claims 1-5, wherein the step of acquiring (301) a first audio decoding parameter comprises:
reading an extended display identification data EDID of the third party terminal through a designated interface; and
acquiring the first audio decoding parameter from the EDID of the third party terminal.

7. The method according to claim 6, wherein the step of acquiring the first audio decoding parameter from the EDID of the third party terminal comprises:
acquiring a data document from the EDID of the third party terminal according to a designated path; and
acquiring the first audio decoding parameter from the data document.

8. The method according to anyone of claims 1-7, wherein before the step of selecting (302) a device with a greater converting capability from the third party terminal and the split type host according to the first audio decoding parameter and a second audio decoding parameter, the method comprises:
reading an extended display identification data EDID of the split type host; and
acquiring the second audio decoding parameter from the EDID of the split type host.

9. The method according to anyone of claims 1-8, wherein the step of selecting (302) a device with a greater converting capability from the third party terminal and the split type host according to the first audio decoding parameter and a second audio decoding parameter comprises:
acquiring a third audio decoding parameter when the split type host is further externally connected to a third party player source having an audio playing function, the third audio decoding parameter being an audio decoding parameter of the third party player source; and
selecting a device with a greater converting capability from the third party terminal, the split type host and the third party player source, according to the first audio decoding parameter, the second audio decoding parameter and the third audio decoding parameter.

10. A device for playing audio, **characterized in that** it comprises:
a first acquiring module (501) configured to acquire a first audio decoding parameter, the first audio decoding parameter being an audio decoding parameter of a third party terminal externally connected to a split type host, the first audio decoding parameter being used for describing a converting capability for converting a digital audio signal into an analog audio signal;
a selection module (502) configured to compare the first audio decoding parameter with the second audio decoding parameter and to select a device with a greater converting capability from the third party terminal and the split type host according to the first audio decoding parameter and a second audio decoding parameter, the second decoding parameter being an audio decoding parameter of the split type host; and
a playing module (503) configured to play the audio using the selected device,
wherein both the first audio decoding parameter and the second audio decoding parameter comprise at least a scheme for audio decoding.

11. The device according to claim 10, wherein the first audio decoding parameter and the second audio decoding parameter further comprise at least one of a sampling frequency and a number of audio channel.

12. The device according to claim 10, wherein the selection module (502) comprises:
a first determining unit (5021) configured to determine a first number and a second number, the first number being a number of the scheme for audio decoding included in the first audio decoding parameter, and the second number being a number of the scheme for audio decoding included in the second audio decoding parameter;
a second determining unit (5022) configured to determine that the third party terminal is the device with a greater converting capability when the first number is greater than the second number; and
a third determining unit (5023) configured to determine that the split type host is the device with a greater converting capability when the first number is smaller than the second number.

13. The device according to claim 12, wherein the selection module (502) further comprises:
a first acquiring unit (5024) configured to acquire a first sampling frequency and a second sampling frequency, the first sampling frequency being a sampling frequency included in the first audio decoding parameter, and the second sampling frequency being a sampling frequency included in the second audio decoding parameter, when the first number equals to the second number and when the first audio decoding parameter and the second audio decoding parameter further comprise a sampling frequency;
a fourth determining unit (5025) configured to determine that the third party terminal is the device with a greater converting capability when the first sampling frequency is greater than the second sampling frequency; and
a fifth determining unit (5026) configured to determine that the split type host is the device with a greater converting capability when the first sampling frequency is smaller than the second sampling frequency.

14. The device according to claim 12, wherein the selection module (502) further comprises:
a second acquiring unit (5027) configured to acquire a first number of audio channel and a second number of audio channel, the first number of audio channel being a number of audio channel included in the first audio decoding parameter, and the second number of audio channel being a number of audio channel included in the second audio decoding parameter, when the first number equals to the second number and when the first audio decoding parameter and the second audio decoding parameter further comprise a number of audio channel;
a sixth determining unit (5028) configured to determine that the third party terminal is the device with a greater converting capability when the first number of audio channel is greater than the second number of audio channel; and
a seventh determining unit (5029) configured to determine that the split type host is the device with a greater converting capability when the first number of audio channel is smaller than the second number of audio channel.

15. A computer program, which when executing on a processor, performs a method for playing audio according to any one of claims 1 to 9.

## Patentansprüche

1. Verfahren zum Wiedergeben von Audio, **dadurch gekennzeichnet, dass** das Verfahren umfasst:
Erlangen (301) eines ersten Audiodecodierungs-Parameters, wobei der erste Audiodecodierungs-Parameter ein Audiodecodierungs-Parameter eines Fremdendgeräts ist, das extern mit einem geteilten Host verbunden ist, wobei der erste Audiodecodierungs-Parameter zum Beschreiben einer Konvertierungsfähigkeit zum Konvertieren eines digitalen Audiosignals in ein analoges Audiosignal verwendet wird,
Vergleichen des ersten Audiodecodierungs-Parameters mit dem zweiten Audiodecodierungs-Parameter und Auswählen (302) einer Vorrichtung mit einer besseren Konvertierungsfähigkeit aus dem Fremdendgerät und dem geteilten Host gemäß dem ersten Audiodecodierungs-Parameter und einem zweiten Audiodecodierungs-Parameter, wobei der zweite Audiodecodierungs-Parameter ein Audiodecodierungs-Parameter des geteilten Hosts ist, und
Wiedergeben (303) des Audios unter Verwendung der ausgewählten Vorrichtung,
wobei sowohl der erste Audiodecodierungs-Parameter als auch der zweite Audiodecodierungs-Parameter mindestens ein Schema zur Audiodecodierung umfassen.

2. Verfahren nach Anspruch 1, wobei der erste Audiodecodierungs-Parameter und der zweite Audiodecodierungs-Parameter ferner mindestens eines von einer Abtastfrequenz und einer Audiokanalanzahl umfassen.

3. Verfahren nach Anspruch 1, wobei der Schritt des Auswählens (302) einer Vorrichtung mit einer besseren Konvertierungsfähigkeit aus dem Fremdendgerät und dem geteilten Host gemäß dem ersten Audiodecodierungs-Parameter und einem zweiten Audiodecodierungs-Parameter umfasst:
Bestimmen einer ersten Anzahl und einer zweiten Anzahl, wobei die erste Anzahl eine Anzahl von Schemata zur Audiodecodierung ist, die in dem ersten Audiodecodierungs-Parameter enthalten sind, und die zweite Anzahl eine Anzahl von Schemata zur Audiodecodierung ist, die in dem zweiten Audiodecodierungs-Parameter enthalten sind,
Bestimmen, dass das Fremdendgerät die Vorrichtung mit einer besseren Konvertierungsfähigkeit ist, wenn die erste Anzahl größer als die zweite Anzahl ist, und
Bestimmen, dass der geteilte Host die Vorrichtung mit einer besseren Konvertierungsfähigkeit ist, wenn die erste Anzahl kleiner als die zweite Anzahl ist.

4. Verfahren nach Anspruch 3, wobei das Verfahren nach dem Schritt des Bestimmens einer ersten Anzahl und einer zweiten Anzahl ferner umfasst:
wenn die erste Anzahl gleich der zweiten Anzahl ist und wenn der erste Audiodecodierungs-Parameter und der zweite Audiodecodierungs-Parameter ferner eine Abtastfrequenz umfassen, Erlangen einer ersten Abtastfrequenz und einer zweiten Abtastfrequenz, wobei die erste Abtastfrequenz eine Abtastfrequenz ist, die in dem ersten Audiodecodierungs-Parameter enthalten ist, und die zweite Abtastfrequenz eine Abtastfrequenz ist, die in dem zweiten Audiodecodierungs-Parameter enthalten ist,
Bestimmen, dass das Fremdendgerät die Vorrichtung mit einer besseren Konvertierungsfähigkeit ist, wenn die erste Abtastfrequenz größer als die zweite Abtastfrequenz ist, und
Bestimmen, dass der geteilte Host die Vorrichtung mit einer besseren Konvertierungsfähigkeit ist, wenn die erste Abtastfrequenz kleiner als die zweite Abtastfrequenz ist.

5. Verfahren nach Anspruch 3, wobei das Verfahren nach dem Schritt des Bestimmens einer ersten Anzahl und einer zweiten Anzahl ferner umfasst:
wenn die erste Anzahl gleich der zweiten Anzahl ist und wenn der erste Audiodecodierungs-Parameter und der zweite Audiodecodierungs-Parameter ferner eine Audiokanalanzahl umfassen, Erlangen einer ersten Audiokanalanzahl und einer zweiten Audiokanalanzahl, wobei die erste Audiokanalanzahl eine Anzahl von Audiokanälen ist, die in dem ersten Audiodecodierungs-Parameter enthalten sind, und die zweite Audiokanalanzahl eine Anzahl von Audiokanälen ist, die in dem zweiten Audiodecodierungs-Parameter enthalten sind,
Bestimmen, dass das Fremdendgerät die Vorrichtung mit einer besseren Konvertierungsfähigkeit ist, wenn die erste Audiokanalanzahl größer als die zweite Audiokanalanzahl ist, und
Bestimmen, dass der geteilte Host die Vorrichtung mit einer besseren Konvertierungsfähigkeit ist, wenn die erste Audiokanalanzahl kleiner als die zweite Audiokanalanzahl ist.

6. Verfahren nach einem der Ansprüche 1 - 5, wobei der Schritt des Erlangens (301) eines ersten Audiodecodierungs-Parameters umfasst:
Lesen von erweiterten Anzeigeidentifikationsdaten EDID des Fremdendgeräts durch eine ausgewählte Schnittstelle und
Erlangen des ersten Audiodecodierungs-Parameters aus den EDID des Fremdendgeräts.

7. Verfahren nach Anspruch 6, wobei der Schritt des Erlangens des ersten Audiodecodierungs-Parameters aus den EDID des Fremdendgeräts umfasst:
Erlangen eines Datendokuments aus den EDID des Fremdendgeräts gemäß einem ausgewählten Pfad und
Erlangen des ersten Audiodecodierungs-Parameters aus dem Datendokument.

8. Verfahren nach einem der Ansprüche 1 - 7, wobei das Verfahren vor dem Schritt des Auswählens (302) einer Vorrichtung mit einer besseren Konvertierungsfähigkeit aus dem Fremdendgerät und dem geteilten Host gemäß dem ersten Audiodecodierungs-Parameter und einem zweiten Audiodecodierungs-Parameter umfasst:
Lesen von erweiterten Anzeigeidentifikationsdaten EDID des geteilten Hosts, und
Erlangen des zweiten Audiodecodierungs-Parameters aus den EDID des geteilten Hosts.

9. Verfahren nach einem der Ansprüche 1 - 8, wobei der Schritt des Auswählens (302) einer Vorrichtung mit einer besseren Konvertierungsfähigkeit aus dem Fremdendgerät und dem geteilten Host gemäß dem ersten Audiodecodierungs-Parameter und einem zweiten Audiodecodierungs-Parameter umfasst:
Erlangen eines dritten Audiodecodierungs-Parameters, wenn der geteilte Host ferner extern mit einer Fremdwiedergabegerätequelle mit einer Audiowiedergabefunktion verbunden ist, wobei der dritte Audiodecodierungs-Parameter ein Audiodecodierungs-Parameter der Fremdwiedergabegerätequelle ist, und
Auswählen einer Vorrichtung mit einer besseren Konvertierungsfähigkeit aus dem Fremdendgerät, dem geteilten Host und der Fremdwiedergabegerätequelle gemäß dem ersten Audiodecodierungs-Parameter, dem zweiten Audiodecodierungs-Parameter und dem dritten Audiodecodierungs-Parameter.

10. Vorrichtung zum Wiedergeben von Audio, **dadurch gekennzeichnet, dass** sie umfasst:
ein erstes Erlangungsmodul (501), das dazu ausgestaltet ist, einen ersten Audiodecodierungs-Parameter zu erlangen, wobei der erste Audiodecodierungs-Parameter ein Audiodecodierungs-Parameter eines Fremdendgeräts ist, das extern mit einem geteilten Host verbunden ist, wobei der erste Audiodecodierungs-Parameter zum Beschreiben einer Konvertierungsfähigkeit zum Konvertieren eines digitalen Audiosignals in ein analoges Audiosignal verwendet wird,
ein Auswahlmodul (502), das dazu ausgestaltet ist, den ersten Audiodecodierungs-Parameter mit dem zweiten Audiodecodierungs-Parameter zu vergleichen und eine Vorrichtung mit einer besseren Konvertierungsfähigkeit aus dem Fremdendgerät und dem geteilten Host gemäß dem ersten Audiodecodierungs-Parameter und einem zweiten Audiodecodierungs-Parameter auszuwählen, wobei der zweite Audiodecodierungs-Parameter ein Audiodecodierungs-Parameter des geteilten Hosts ist, und
ein Wiedergabemodul (503), das dazu ausgestaltet ist, das Audio unter Verwendung der ausgewählten Vorrichtung wiederzugeben,
wobei sowohl der erste Audiodecodierungs-Parameter als auch der zweite Audiodecodierungs-Parameter mindestens ein Schema zur Audiodecodierung umfassen.

11. Vorrichtung nach Anspruch 10, wobei der erste Audiodecodierungs-Parameter und der zweite Audiodecodierungs-Parameter ferner mindestens eines von einer Abtastfrequenz und einer Audiokanalanzahl umfassen.

12. Vorrichtung nach Anspruch 10, wobei das Auswahlmodul (502) umfasst:
eine erste Bestimmungseinheit (5021), die dazu ausgestaltet ist, eine erste Anzahl und eine zweite Anzahl zu bestimmen, wobei die erste Anzahl eine Anzahl von Schemata zur Audiodecodierung ist, die in dem ersten Audiodecodierungs-Parameter enthalten sind, und die zweite Anzahl eine Anzahl von Schemata zur Audiodecodierung ist, die in dem zweiten Audiodecodierungs-Parameter enthalten sind,
eine zweite Bestimmungseinheit (5022), die dazu ausgestaltet ist, zu bestimmen, dass das Fremdendgerät die Vorrichtung mit einer besseren Konvertierungsfähigkeit ist, wenn die erste Anzahl großer als die zweite Anzahl ist, und
eine dritte Bestimmungseinheit (5023), die dazu ausgestaltet ist, zu bestimmen, dass der geteilte Host die Vorrichtung mit einer besseren Konvertierungsfähigkeit ist, wenn die erste Anzahl kleiner als die zweite Anzahl ist.

13. Vorrichtung nach Anspruch 12, wobei das Auswahlmodul (502) ferner umfasst:
eine erste Erlangungseinheit (5024), die dazu ausgestaltet ist, eine erste Abtastfrequenz und eine zweite Abtastfrequenz zu erlangen, wobei die erste Abtastfrequenz eine Abtastfrequenz ist, die in dem ersten Audiodecodierungs-Parameter enthalten ist, und die zweite Abtastfrequenz eine Abtastfrequenz ist, die in dem zweiten Audiodecodierungs-Parameter enthalten ist, wenn die erste Anzahl gleich der zweiten Anzahl ist und wenn der erste Audiodecodierungs-Parameter und der zweite Audiodecodierungs-Parameter ferner eine Abtastfrequenz umfassen,
eine vierte Bestimmungseinheit (5025), die dazu ausgestaltet ist, zu bestimmen, dass das Fremdendgerät die Vorrichtung mit einer besseren Konvertierungsfähigkeit ist, wenn die erste Abtastfrequenz größer als die zweite Abtastfrequenz ist, und
eine fünfte Bestimmungseinheit (5026), die dazu ausgestaltet ist, zu bestimmen, dass der geteilte Host die Vorrichtung mit einer besseren Konvertierungsfähigkeit ist, wenn die erste Abtastfrequenz kleiner als die zweite Abtastfrequenz ist.

14. Vorrichtung nach Anspruch 12, wobei das Auswahlmodul (502) ferner umfasst:
eine zweite Erlangungseinheit (5027), die dazu ausgestaltet ist, eine erste Audiokanalanzahl und eine zweite Audiokanalanzahl zu erlangen, wobei die erste Audiokanalanzahl eine Anzahl von Audiokanälen ist, die in dem ersten Audiodecodierungs-Parameter enthalten sind, und die zweite Audiokanalanzahl eine Anzahl von Audiokanälen ist, die in dem zweiten Audiodecodierungs-Parameter enthalten sind, wenn die erste Anzahl gleich der zweiten Anzahl ist und wenn der erste Audiodecodierungs-Parameter und der zweite Audiodecodierungs-Parameter ferner eine Audiokanalanzahl umfassen,
eine sechste Bestimmungseinheit (5028), die dazu ausgestaltet ist, zu bestimmen, dass das Fremdendgerät die Vorrichtung mit einer besseren Konvertierungsfähigkeit ist, wenn die erste Audiokanalanzahl größer als die zweite Audiokanalanzahl ist, und
eine siebte Bestimmungseinheit (5029), die dazu ausgestaltet ist, zu bestimmen, dass der geteilte Host die Vorrichtung mit einer besseren Konvertierungsfähigkeit ist, wenn die erste Audiokanalanzahl kleiner als die zweite Audiokanalanzahl ist.

15. Computerprogramm, das bei Ausführung auf einem Prozessor ein Verfahren zum Wiedergeben von Audio nach einem der Ansprüche 1 bis 9 durchführt.

## Revendications

1. Procédé de lecture audio, **caractérisé en ce que** le procédé comprend :
l'acquisition (301) d'un premier paramètre de décodage audio, le premier paramètre de décodage audio étant un paramètre de décodage audio d'un terminal tiers relié en externe à un hôte de type scindé, le premier paramètre de décodage audio étant utilisé pour décrire une capacité de conversion pour convertir un signal audio numérique en un signal audio analogique ;
la comparaison du premier paramètre de décodage audio avec le second paramètre de décodage audio et la sélection (302) d'un dispositif qui présente une plus grande capacité de conversion parmi le terminal tiers et l'hôte de type scindé selon le premier paramètre de décodage audio et un second paramètre de décodage audio, le second paramètre de décodage étant un paramètre de décodage audio de l'hôte de type scindé ; et
la lecture (303) de l'audio à l'aide du dispositif sélectionné,
dans lequel le premier paramètre de décodage audio et le second paramètre de décodage audio comprennent au moins un modèle de décodage audio.

2. Procédé selon la revendication 1, dans lequel le premier paramètre de décodage audio et le second paramètre de décodage audio comprennent en outre au moins l'un d'une fréquence d'échantillonnage et d'un nombre de canaux audio.

3. Procédé selon la revendication 1, dans lequel l'étape de sélection (302) d'un dispositif qui présente une plus grande capacité de conversion parmi le terminal tiers et l'hôte de type scindé selon le premier paramètre de décodage audio et un second paramètre de décodage audio comprend :
la détermination d'un premier nombre et d'un second nombre, le premier nombre étant un nombre du modèle de décodage audio inclus dans le premier paramètre de décodage audio, et le second nombre étant un nombre du modèle de décodage audio inclus dans le second paramètre de décodage audio ;
la détermination du fait que le terminal tiers soit le dispositif qui présente une plus grande capacité de conversion lorsque le premier nombre est supérieur au second nombre ; et
la détermination du fait que l'hôte de type scindé soit le dispositif qui présente une plus grande capacité de conversion lorsque le premier nombre est inférieur au second nombre.

4. Procédé selon la revendication 3, dans lequel, après l'étape de détermination d'un premier nombre et d'un second nombre, le procédé comprend en outre :
lorsque le premier nombre est égal au second nombre et lorsque le premier paramètre de décodage audio et le second paramètre de décodage audio comprennent en outre une fréquence d'échantillonnage, l'acquisition d'une première fréquence d'échantillonnage et d'une seconde fréquence d'échantillonnage, la première fréquence d'échantillonnage étant une fréquence d'échantillonnage incluse dans le premier paramètre de décodage audio, et la seconde fréquence d'échantillonnage étant une fréquence d'échantillonnage incluse dans le second paramètre de décodage audio ;
la détermination du fait que le terminal tiers soit le dispositif qui présente une plus grande capacité de conversion lorsque la première fréquence d'échantillonnage est supérieure à la seconde fréquence d'échantillonnage ; et
la détermination du fait que l'hôte de type scindé soit le dispositif qui présente une plus grande capacité de conversion lorsque la première fréquence d'échantillonnage est inférieure à la seconde fréquence d'échantillonnage.

5. Procédé selon la revendication 3, dans lequel, après l'étape de détermination d'un premier nombre et d'un second nombre, le procédé comprend en outre :
lorsque le premier nombre est égal au second nombre et lorsque le premier paramètre de décodage audio et le second paramètre de décodage audio comprennent en outre un nombre de canaux audio, l'acquisition d'un premier nombre de canaux audio et d'un second nombre de canaux audio, le premier nombre de canaux audio étant un nombre de canaux audio inclus dans le premier paramètre de décodage audio, et le second nombre de canaux audio étant un nombre de canaux audio inclus dans le second paramètre de décodage audio ;
la détermination du fait que le terminal tiers soit le dispositif qui présente une plus grande capacité de conversion lorsque le premier nombre de canaux audio est supérieur au second nombre de canaux audio ; et
la détermination du fait que l'hôte de type scindé soit le dispositif qui présente une plus grande capacité de conversion lorsque le premier nombre de canaux audio est inférieur au second nombre de canaux audio.

6. Procédé selon l'une quelconque des revendications 1 à 5, dans lequel l'étape d'acquisition (301) d'un premier paramètre de décodage audio comprend :
la lecture de données d'identification d'affichage étendu (EDID) du terminal tiers par le biais d'une interface désignée ; et
l'acquisition du premier paramètre de décodage audio à partir des EDID du terminal tiers.

7. Procédé selon la revendication 6, dans lequel l'tape d'acquisition du premier paramètre de décodage audio à partir des EDID du terminal tiers comprend :
l'acquisition d'un document de données à partir des EDID du terminal tiers selon un chemin désigné ; et
l'acquisition du premier paramètre de décodage audio à partir du document de données.

8. Procédé selon l'une quelconque des revendications 1 à 7, dans lequel, avant l'étape de sélection (302) d'un dispositif qui présente une plus grande capacité de conversion parmi le terminal tiers et l'hôte de type scindé selon le premier paramètre de décodage audio et un second paramètre de décodage audio, le procédé comprend :
la lecture de données d'identification d'affichage étendu (EDID) de l'hôte de type scindé ; et
l'acquisition du second paramètre de décodage audio à partir des EDID de l'hôte de type scindé.

9. Procédé selon l'une quelconque des revendications 1 à 8, dans lequel l'étape de sélection (302) d'un dispositif qui présente une plus grande capacité de conversion parmi le terminal tiers et l'hôte de type scindé selon le premier paramètre de décodage audio et un second paramètre de décodage audio comprend :
l'acquisition d'un troisième paramètre de décodage audio lorsque l'hôte de type scindé est également relié en externe à une source de lecture tiers ayant une fonction de lecture audio, le troisième paramètre de décodage audio étant un paramètre de décodage audio de la source de lecture tiers ; et
la sélection d'un dispositif qui présente une plus grande capacité de conversion parmi le terminal tiers, l'hôte de type scindé et la source de lecture tiers, selon le premier paramètre de décodage audio, le second paramètre de décodage audio et le troisième paramètre de décodage audio.

10. Dispositif de lecture audio, **caractérisé en ce qu'**il comprend :
un premier module d'acquisition (501) configuré pour acquérir un premier paramètre de décodage audio, le premier paramètre de décodage audio étant un paramètre de décodage audio d'un terminal tiers relié en externe à un hôte de type scindé, le premier paramètre de décodage audio étant utilisé pour décrire une capacité de conversion pour convertir un signal audio numérique en un signal audio analogique ;
un module de sélection (502) configuré pour comparer le premier paramètre de décodage audio avec le second paramètre de décodage audio et pour sélectionner un dispositif qui présente une plus grande capacité de conversion parmi le terminal tiers et l'hôte de type scindé selon le premier paramètre de décodage audio et un second paramètre de décodage audio, le second paramètre de décodage étant un paramètre de décodage audio de l'hôte de type scindé ; et
un module de lecture (503) configuré pour lire l'audio à l'aide du dispositif sélectionné,
dans lequel le premier paramètre de décodage audio et le second paramètre de décodage audio comprennent au moins un modèle de décodage audio.

11. Dispositif selon la revendication 10, dans lequel le premier paramètre de décodage audio et le second paramètre de décodage audio comprennent en outre au moins l'un d'une fréquence d'échantillonnage et d'un nombre de canaux audio.

12. Dispositif selon la revendication 10, dans lequel le module de sélection (502) comprend :
une première unité de détermination (5021) configurée pour déterminer un premier nombre et un second nombre, le premier nombre étant un nombre du modèle de décodage audio inclus dans le premier paramètre de décodage audio, et le second nombre étant un nombre du modèle de décodage audio inclus dans le second paramètre de décodage audio ;
une seconde unité de détermination (5022) configurée pour déterminer que le terminal tiers est le dispositif qui présente une plus grande capacité de conversion lorsque le premier nombre est supérieur au second nombre ; et
une troisième unité de détermination (5023) configurée pour déterminer que l'hôte de type scindé est le dispositif qui présente une plus grande capacité de conversion lorsque le premier nombre est inférieur au second nombre.

13. Dispositif selon la revendication 12, dans lequel le module de sélection (502) comprend en outre :
une première unité d'acquisition (5024) configurée pour acquérir une première fréquence d'échantillonnage et une seconde fréquence d'échantillonnage, la première fréquence d'échantillonnage étant une fréquence d'échantillonnage incluse dans le premier paramètre de décodage audio, et la seconde fréquence d'échantillonnage étant une fréquence d'échantillonnage incluse dans le second paramètre de décodage audio, lorsque le premier nombre est égal au second nombre et lorsque le premier paramètre de décodage audio et le second paramètre de décodage audio comprennent en outre une fréquence d'échantillonnage ;
une quatrième unité de détermination (5025) configurée pour déterminer que le terminal tiers est le dispositif qui présente une plus grande capacité de conversion lorsque la première fréquence d'échantillonnage est supérieure à la seconde fréquence d'échantillonnage ; et
une cinquième unité de détermination (5026) configurée pour déterminer que l'hôte de type scindé est le dispositif qui présente une plus grande capacité de conversion lorsque la première fréquence d'échantillonnage est inférieure à la seconde fréquence d'échantillonnage.

14. Dispositif selon la revendication 12, dans lequel le module de sélection (502) comprend en outre :
une seconde unité d'acquisition (5027) configurée pour acquérir un premier nombre de canaux audio et un second nombre de canaux audio, le premier nombre de canaux audio étant un nombre de canaux audio inclus dans le premier paramètre de décodage audio, et le second nombre de canaux audio étant un nombre de canaux audio inclus dans le second paramètre de décodage audio, lorsque le premier nombre est égal au second nombre et lorsque le premier paramètre de décodage audio et le second paramètre de décodage audio comprennent en outre un nombre de canaux audio ;
une sixième unité de détermination (5028) configurée pour déterminer que le terminal tiers est le dispositif qui présente une plus grande capacité de conversion lorsque le premier nombre de canaux audio est supérieur au second nombre de canaux audio ; et
une septième unité de détermination (5029) configurée pour déterminer que l'hôte de type scindé est le dispositif qui présente une plus grande capacité de conversion lorsque le premier nombre de canaux audio est inférieur au second nombre de canaux audio.

15. Programme informatique, qui, lorsqu'il est exécuté sur un processeur, exécute un procédé de lecture audio selon l'une quelconque des revendications 1 à 9.
